# EUROPÄISCHE PATENTSCHRIFT

(11) **EP 0 715 351 B1**
(45) Veröffentlichungstag und Bekanntmachung des Hinweises auf die Patenterteilung: **10.07.2002**
(21) Anmeldenummer: 95118892.9
(22) Anmeldetag: 30.11.1995
(51) Int. Cl.: H01L 23/051, H01L 23/31

(54) **Leistungs-Halbleiterbauelement**
Semiconductor power component
Composant semi-conducteur de puissance

(30) Priorität: 02.12.1994 DE 4443271
(43) Veröffentlichungstag der Anmeldung: 05.06.1996
(73) Patentinhaber: eupec Europäische Gesellschaft für Leistungshalbleiter mbH & Co. KG, 59581 Warstein (DE)
(72) Erfinder: Voss, Peter, Dr.-Ing., D-81925 München (DE)
(74) Vertreter: Schmuckermaier, Bernhard

(56) Entgegenhaltungen:
- EP-A- 0 242 626
- EP-A- 0 365 007
- US-A- 3 586 932
- US-A- 3 654 529
- US-A- 3 681 667
- PATENT ABSTRACTS OF JAPAN vol. 017 no. 398 (E-1403) ,26.Juli 1993 & JP-A-05 074824 (MITSUBISHI ELECTRIC CORP) 26.März 1993,

## Beschreibung

Die Erfindung bezieht sich auf ein Verfahren zum Herstellen eines Leistungs-Halbleiterbauelementes mit
- einem Halbleiterkörper, der eine erste und eine zweite Hauptfläche aufweist,
- eine auf der ersten Hauptfläche angeordnet Kathoden-Elektrode, wobei die erste Hauptfläche einen abgeschrägten Randbereich aufweist,
- eine auf der zweiten Hauptfläche angeordnete Anoden-Elektrode, die einen größeren Durchmesser als Kathoden-Elektrode und einen kleineren Durchmesser als der Halbleiterkörper aufweist.

Leistungs-Halbleiterbauelemente der genannten Art sind z.B. in der EP 0242 626 und der DE 36 33 266 beschrieben worden. Sie haben im Gegensatz zu den meist eingesetzten Leistungs-Halbleiterbauelementen eine Anoden-Elektrode, die durch Drucksintern oder Diffusionsschweißen mit dem Halbleiterkörper verbunden ist und nicht durch Legieren. Das Diffusionsschweißen und das Drucksintern erfordert gegenüber dem Legieren eine niedrigere Temperatur, jedoch einen hohen Druck. Damit läßt sich eine lunkerfreie, stoffschlüssige Verbindung zwischen der Anoden-Elektrode und dem Halbleiterkörper herstellen.

Aufgrund des hohen Drucks beim Anbringen der Anoden-Elektrode wurden bisher Katoden-Elektrode und Anoden-Elektrode deckungsgleich ausgebildet. Besonders bei Leistungs-Halbleiterbauelementen, deren katodenseitige Oberfläche eine negative Abschrägung von z.B. 4° aufweist - bleibt dadurch ein relativ großer Randbereich des Halbleiterkörpers unzureichend gekühlt. Dies hat eine verminderte Temperaturbelastbarkeit und damit eine verminderte Stromtragfähigkeit zur Folge.

Aus der US 3,586,932 ist ein Verfahren zur Herstellung eines gattungsgemäßen Leistungs-Halbleiterbauelementes bekannt, bei dem zunächst eine Verbindung zwischen dem Halbleiterkörper und einer Elektrode hergestellt wird. Anschließend wird eine isolierende Hülle um die gesamte Anordnung angebracht.

Aus der EP 0365 007 ist eine Thyristor-Anordnung bekannt, bei der auf eine stoffschlüssige Verbindung zwischen den Elektroden und dem Halbleiterkörper verzichtet ist. Die Elektroden sind als Molybdänscheiben ausgeführt, die zwischen dem Halbleiterkörper und einer weiteren Elektrodenscheibe geklemmt sind. Diese Anordnung weist den Nachteil auf, daß die Kathoden- bzw. Anodenscheiben nichts zur Kühlung des Bauelementes bei hohen Strömen beitragen können.

Der Erfindung liegt die Aufgabe zugrunde, ein Verfahren bereit zu stellen, das eine unkomplizierte und möglichst risikolose Herstellung solcher Leistungs-Halbleiterbauelemente mit einer verbesserten Stromtragfähigkeit ermöglicht.

Diese Aufgabe wird durch die Merkmale des Anspruchs 1 gelöst.

Weiterbildungen der Erfindung sind Gegenstand der Unteransprüche.

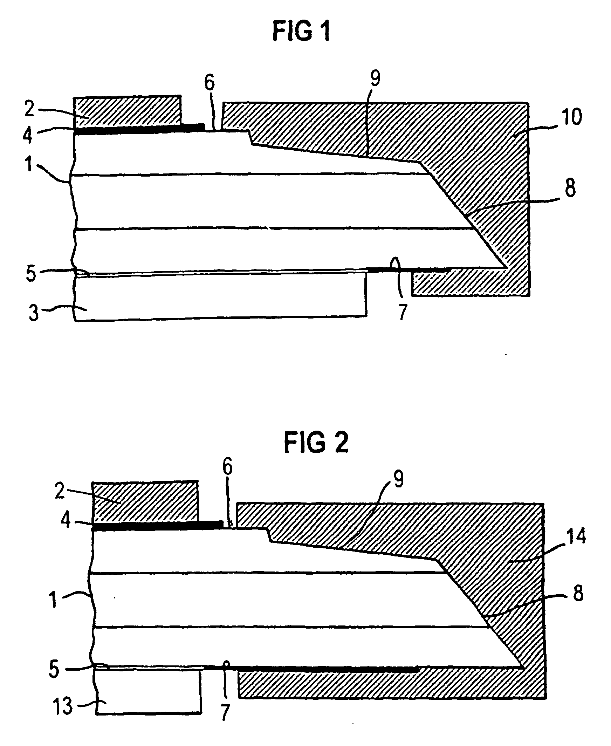

Die Erfindung wird anhand eines Ausführungsbeispiels in Verbindung mit Figur 1 näher erläutert. In Figur 2 ist ein Leistungs-Halbleiterbauelement gemäß dem Stand der Technik dargestellt.

Das Leistungs-Halbleiterbauelement nach Figur 2 hat einen Halbleiterkörper 1, der über eine Katoden-Elektrode 2 und eine Anoden-Elektrode 13 kontaktiert ist. Die Kontakte bestehen üblicherweise aus Molybdän. Auf der katodenseitigen Oberfläche 6 ist eine Metallschicht 4 aufgebracht, auf der anodenseitigen Oberfläche 7 eine Metallschicht 5. Die Metallschichten enthalten ein Metall oder eine Metallegierung, die unter Druck und relativ niedriger Temperatur eine Diffusionslötung oder eine Sinterverbindung zwischen den Elektroden 2, 13 und dem Halbleiterkörper 1 bewirkt. Zur Technik der Sinterverbindung wird beispielsweise auf das erwähnte europäische Patent 0 242 626 hingewiesen, zur Technik der Diffusionslötung z. B. auf die erwähnte deutsche Anmeldung 36 33 266. Eine Erläuterung der einzelnen Verfahrensschritte erübrigt sich daher hier.

Die Elektroden 2, 13 sind deckungsgleich, d.h. sie haben den gleichen Durchmesser und sind einander gegenüberliegend angebracht. Die katodenseitige Oberfläche 6 hat einen unter einem negativen Winkel abgeschrägten Randbereich 9. Dieser Winkel ist üblicherweise größer als 0° und kleiner als 10°. Der Rand des Halbleiterkörpers hat zusätzlich eine unter einem positiven Winkel abgeschrägte Fläche 8. Der Abschrägungswinkel liegt hier im allgemeinen zwischen 20° und 60°. Der Rand des Halbleiterkörpers ist von einer isolierenden Hülle 10, z.B. aus Silikonkautschuk, umgeben, die auch einen Teil der katodenseitigen Oberfläche 6, den Randbereich 9, die Randfläche 8 und einen Teil der anodenseitigen Oberfläche 7 bedeckt.

Der Rand des Halbleiterkörpers des Leistungs-Halbleiterbauelements nach Figur 2 wird lediglich über die seitliche Wärmeabfuhr zur Elektrode 2 und zur Elektrode 13 gekühlt. Die Strombelastbarkeit dieses Halbleiterbauelements ist daher vermindert.

Das in Figur 1 dargestellte Halbleiterbauelement gemäß Erfindung unterscheidet sich von dem nach Figur 2 hauptsächlich dadurch, daß es eine Anoden-Elektrode 3 hat, deren Durchmesser größer ist als der der Katoden-Elektrode 2. Aus herstellungstechnischen Gründen reicht die Anoden-Elektrode 3 jedoch nicht bis zum Rand des Halbleiterkörpers, sie endet vielmehr unterhalb des abgeschrägten Bereichs 9. Sie kann auch bis unter den abgeschrägten Rand 8 reichen. Damit kann die Kühlung des Halbleiterkörpers entscheidend verbessert werden. Die Strombelastbarkeit wird dadurch erhöht.

Die unterschiedlich großen Elektroden 2, 3 werden durch Diffusionsschweißen oder Drucksintern angebracht. Die dabei auftretende Biegebeanspruchung des Halbleiterkörpers läßt sich durch geeignete Preßvorrichtungen, z. B. mit elastischen Einlagen, auf ein für den Halbleiterkörper ungefährliches Maß absenken. Zweckmäßigerweise wird die Hülle 10 vor dem Anbringen der Elektroden aufgebracht. Besteht sie z. B. aus Silikonkautschuk, so kann sie zum Vergleichmäßigen des Preßdrucks mit herangezogen werden.

Die im Vergleich zur Katoden-Elektrode 2 größere Anoden-Elektrode 3 erfordert im Gegensatz zu Figur 2 eine unsymmetrische isolierende Hülle. Diese ist mit 10 bezeichnet. Die isolierende Schicht kann wie erwähnt, aus Silikonkautschuk bestehen, der alle an die Oberfläche tretenden pn-Übergänge des Halbleiterkörpers bedeckt. Die auf der anodenseitigen Oberfläche 7 aufgebrachte Metallschicht 5 kann dabei vom Kautschuk überdeckt werden. Damit erübrigt sich eine exakte Justierung zwischen Kautschuk und Metallschicht.

Im Ausführungsbeispiel wurde angegeben, daß sowohl die Katoden-Elektrode 2 als auch die Anoden-Elektrode 3 durch Diffusionslöten oder Drucksintern mit dem Halbleiterkörper verbunden sind. Es ist jedoch auch möglich, die genannten Verfahren nur auf der Anodenseite anzuwenden. Außerdem ist es möglich, die Erfindung bei einem Leistungs-Halbleiterbauelement anzuwenden, dessen katodenseitige Randfläche 9 nicht unter einem Winkel zwischen 0° und 10° bezüglich der Flächen der Elektroden geneigt ist. Die Randfläche 9 kann auch parallel zur Hauptfläche der Elektroden liegen, wenn die Sperrfähigkeit des Randes z.B. über gestufte Diffusionen eingestellt wird (Planarrand).

## Patentansprüche

1. Verfahren zur Herstellung eines Leistungs-Halbleiterbauelementes mit:
- einem Halbleiterkörper (1), der eine erste und eine zweite Hauptfläche aufweist,
- eine auf der ersten Hauptfläche angeordnete Kathoden-Elektrode (2), wobei die erste Hauptfläche einen abgeschrägten Randbereich (8, 9) aufweist,
- eine auf der zweiten Hauptfläche angeordnete Anoden-Elektrode (3) die einen größeren Durchmesser als die Kathoden-Elektrode (2) und einen kleineren Durchmesser als der Halbleiterkörper (1) aufweist,
mit den nachfolgenden Schritten:
a) Aufbringen einer Metallschicht auf der zweiten Hauptfläche,
b) Bedecken des Halbleiterkörpers (1) außerhalb der Elektroden (2, 3) mit einer isolierenden Hülle (10),
c) Herstellen einer stoffschlüssigen Verbindung mindestens zwischen der Anoden-Elektrode (3) und dem Halbleiterkörper (1) durch Drucksintern oder Diffusionsschweißen

2. Verfahren nach Anspruch 1,
wobei die isolierende Hülle (10) derart unsymmetrisch auf den Halbleiterkörper (1) aufgebracht wird, daß sie einen Teil der kathodenseitigen Oberfläche (6), den Randbereich (9), die Randfläche (8) und die anodenseitige Oberfläche (7) bis maximal unterhalb des abgeschrägten Randbereiches (9) bedeckt und
die Anoden-Elektrode (3) auf die verbleibende Fläche der anodenseitigen Oberfläche (7) von der isolierenden Hülle (10) zurückgesetzt angebracht wird.

3. Verfahren nach Anspruch 2,
wobei die isolierende Hülle (10) derart aufgebracht wird, daß sie die Metallschicht (5) teilweise überdeckt.

4. Verfahren nach einem der Ansprüche 1 bis 3,
wobei vor der Herstellung der stoffschlüssigen Verbindung durch Drucksintern oder Diffusionsschweißen Preßvorrichtungen angebracht werden.

## Claims

1. Method for the manufacture of a power semiconductor device with:
- a semiconductor body (1), which has a first and a second main surface,
- a cathode electrode (2) arranged on the first main surface, the first main surface having a chamfered edge region (8, 9),
- an anode electrode (3) arranged on the second main surface, the anode electrode having a larger diameter than the cathode electrode (2) and a smaller diameter than the semiconductor body (1),
with the following steps:
a) application of a metal coating on the second main surface,
b) covering of the semiconductor body (1) outside the electrodes (2, 3) with an insulating cover (10),
c) making a positive joint at least between the anode electrode (3) and the semiconductor body (1) by pressure sintering or diffusion welding.

2. Method according to Claim 1, the insulating cover (10) being attached asymmetrically to the semiconductor body (1) in such a way that it covers part of the cathode-side surface (6), the edge region (9), the edge surface (8) and the anode-side surface (7) as a maximum up to beneath the chamfered edge region (9), and the anode electrode (3) being attached to the remaining surface of the anode-side surface (7) set back from the insulating cover (10).

3. Method according to Claim 2, the insulating cover (10) being applied in such a way that it partly covers the metal coating (5).

4. Method according to one of Claims 1 to 3, compression devices being attached before the positive joint is made by pressure sintering or diffusion welding.

## Revendications

1. Procédé pour fabriquer un composant semi-conducteur de puissance avec
- un corps semi-conducteur (1) qui présente une première et une deuxième surface principale,
- une électrode à cathodes (2) placée sur la première surface principale, la première surface principale présentant une zone périphérique biseautée (8, 9),
- une électrode à anodes (3) placée sur la deuxième surface principale, et qui présente un diamètre supérieur à l'électrode cathode (2) et un diamètre inférieur au corps semi-conducteur (1),
**caractérisé par** les étapes suivantes :
a) application d'une couche métallique sur la deuxième surface principale,
b) recouvrement du corps semi-conducteur (1) à l'extérieur des électrodes (2, 3) avec une gaine isolante (10),
c) production d'une liaison à matière jointive par frittage sous pression ou soudage par diffusion au moins entre l'électrode à anodes (3) et le corps semi-conducteur (1).

2. Procédé selon la revendication 1,
**caractérisé en ce que**
d'après lequel la gaine isolante (10) est appliquée de façon dissymétrique sur le corps semi-conducteur (1) de telle sorte qu'elle recouvre une partie de la surface (6) du côté cathode, la zone périphérique (9), la surface périphérique (8) et la surface (7) du côté anode au maximum jusqu'au-dessous de la zone périphérique (9) biseautée, et l'électrode à anodes (3) est appliquée sur la surface restante de la surface (7) du côté anode reculée par rapport à la gaine isolante (10).

3. Procédé selon la revendication 2,
**caractérisé en ce que**
la gaine isolante (10) est appliquée de telle sorte qu'elle recouvre partiellement la couche métallique (5).

4. Procédé selon l'une des revendications 1 à 3,
**caractérisé en ce qu'**
on applique des dispositifs de pressage avant la production de la liaison à matière jointive par frittage sous pression ou par soudage par diffusion.
